# EUROPEAN PATENT SPECIFICATION

(11) **EP 0 608 051 B1**
(45) Date of publication and mention of the grant of the patent: **03.12.1997**
(21) Application number: 94300096.8
(22) Date of filing: 07.01.1994
(51) Int. Cl.: H01L 23/24, H01L 23/04

(54) **Resin-sealed semiconductor device**
In Harz versiegelte Halbleiteranordnung
Dispositif semi-conducteur scellé par une résine

(30) Priority: 13.01.1993 JP 3646/93; 06.05.1993 JP 104849/93
(43) Date of publication of application: 27.07.1994
(60) Divisional application: 96114416.9
(73) Proprietor: FUJI ELECTRIC CO. LTD., Kawasaki 210 (JP)
(72) Inventor: Haraguchi, Koichi, Kawasaki-ku, Kawasaki (JP); Ichimura, Yuji, Kawasaki-ku, Kawasaki (JP)
(74) Representative: Bridge-Butler, Alan James

(56) References cited:
- EP-A- 0 501 341
- DE-A- 4 135 183
- PATENT ABSTRACTS OF JAPAN vol. 017, no. 071 (E-1319) 12 February 1993 & JP-A-04 274 350 (FUJI ELECTRIC CO LTD) 30 September 1992
- PATENT ABSTRACTS OF JAPAN vol. 010, no. 121 (E-401) 7 May 1096 & JP-A-60 254 643 (TOSHIBA KK) 16 December 1985
- PATENT ABSTRACTS OF JAPAN vol. 010, no. 347 (E-457) 21 November 1986 & JP-A-61 148 845 (MITSUBISHI ELECTRIC CORP.) 7 July 1986
- PATENT ABSTRACTS OF JAPAN vol. 009, no. 277 (E-355) 6 November 1985 & JP-A-60 119 759 (MITSUBISHI DENKI KK) 27 June 1985
- PATENT ABSTRACTS OF JAPAN vol. 012, no. 425 (E-681) 10 November 1988 & JP-A-63 164 245 (HITACHI LTD) 7 July 1988

## Description

This invention relates to a resin-sealed semiconductor device, and particularly relates to a resin-sealed transistor module.

Figure 3 shows a conventional resin-sealed semiconductor device. In this diagram, reference number 1 designates a metallic base plate that also serves as a heat radiation plate, reference number 2 a semiconductor element that is mounted on metallic base plate 1 via substrate 3, reference number 4 a lead-out terminal soldered to the surface electrode of semiconductor element 2 or to the conductor pattern of substrate 3 and drawn out upwardly. Reference number 5 indicates a moulded resin covering case bonded with adhesive 6 to the peripheral edge of the metallic base plate 1, and a moulded resin terminal-supporting plate 7 serves as the case lid on the upper surface of covering case 5. A sealing resin 8 fills the inside of covering case 5. In addition, there are also two different types of sealing resin 8: one is made entirely of epoxy resin, and the other is divided into two layers (upper and lower), wherein the lower layer is made of silicon gel and the upper layer is made of epoxy resin. In the two-layered (upper and lower) sealing resin 8, as the cross-sectional view of Figure 4 shows, a step 5a is usually formed on the inner surface of covering case 5, and filling the inside of covering case 5 with silicon gel 8a stops before the level of silicon gel 8a reaches the step 5a. The remaining portion is filled with epoxy resin 8b to harden the inside of covering case 5. Such a device is known from Patent Abstracts of Japan vol. 10, no. 121 (E-401) 7th May 1986, & JP-A-60 254 643.

Although the type of resin material for covering case 5 and terminal-supporting plate 7 are selected in consideration of their resistance to heat, flameproofing property, colouring property, electrical characteristics, and moulding costs, usually PBT (polybutylene terephthalate) resin or PPS (polyphenylene sulfide) resin is used for covering case 5 and PPS resin for terminal-supporting plate 7.

According to the configuration of said conventional resin-sealed semiconductor device, peeling occurs in between the components during actual use or in temperature cycle tests by mutual adhesive failure. This peeling further causes problems such as degrading of moisture resistance performance of the device and leaking of the sealing resin (gelatinoid filler) from the covering case. In particular, the adherent surface between the covering case and the sealing resin, and the adherent surface between the terminal-supporting plate and the sealing resin easily separate. Epoxy resin is used as the sealing resin and solidified at about 135°C. The transition temperature required to solidify epoxy resin into glass is 140 - 160°C, and at temperatures below that range the elasticity of the hardened epoxy resin is highly stable at approximately 1,200 kg/mm². The glass transition temperature for PPS resin is 80 - 90°C, and although at temperatures below this range the elasticity of PPS resin is very stable at approximately about 1,800 kg/mm², at temperatures above this range the elasticity of the PPS resin tends gradually to decrease. Accordingly, for a covering case and terminal-supporting plate made of PPS resin, in order to fill the inside of the covering case and solidify the PPS resin at about 135°C, since the elasticity of the PPS resin, which decreases somewhat, does not change considerably, a difference in the elasticity of the PPS resin and the epoxy resins arises, causing further latent stress in the adherent surface between the covering case and the sealing resin, and between the terminal-supporting plate and the sealing resin. Since an external mechanical stress such as high tension or bending load is likely to be applied to said adherent surfaces during connection of the external wiring to lead-out terminals, peeling can occur not only between the terminal-supporting plate which supports the lead-out terminals and the sealing resin, but also between the covering case and the sealing resin. When the lead-out terminal comes loose due to the peeling thus caused, stress is also applied to the soldered sections between the lead-out terminals and the semiconductor device, thereby causing serious defects such as damage to the semiconductor device.

Furthermore, when an attempt is made to use an adhesive to solidify the adhesive used to bond the metallic base plate to the external covering case, the adhesive runs out of the adherent section and then under the lower surface of the metallic base plate and adheres thereto, thereby damaging the smoothness of the mounting surface, reducing the adhesiveness of the semiconductor device to an apparatus, degrading the heat radiation performance of the semiconductor device, or causing the adhesive to further run into the screw holes prepared on the metallic base plate for mounting the semiconductor device, thereby preventing the mounting of the semiconductor device, or loosening the screws in use.

Given the above situation, the object of the present invention is to provide a stiff and highly reliable resin-sealed semiconductor device by resolving said problems, and by preventing the adhesive between structural components from losing its adhesive properties.

In order to achieve the aforementioned objects, the outer peripheral surface of the terminal-supporting plate is inclined upwardly, while the surface of the covering case facing the inclined outer peripheral surface is inclined downwardly. Furthermore, by unevenly finishing either one of the inclined outer peripheral surface of the terminal-supporting plate and the inclined surface of the covering case facing the inclined outer peripheral surface, the aforementioned objective can be achieved most effectively.

Moreover, by forming a configuration such that a circumferential (first) groove is prepared in the peripheral section of the upper surface of the metallic base plate, and a circumferential (second) groove is prepared in the end face of the lower section of the covering case in such a way as to be deeper than said groove in the base plate, to be wider than the distance between the edge of the base plate and its groove,and to have its inner wall thinner than the width of said groove in the base plate, and such that the metallic base plate and the covering case are made to adhere to each other using adhesive with the inner wall of the groove in the covering case fitted into said groove in the base plate and the outer wall of said groove in the base plate fitted into said groove in the covering case, the adhesive used to bond the metallic base plate and the covering case can be prevented from leaking, and the adhesive will bond the components securely. In this case, adhesion can be made more effective by roughening the surface of the inner wall remote from the groove in the covering case (the second groove).

As the aforementioned configuration proves, when the outer peripheral surface of the terminal-supporting plate or the inner wall surface of the covering case that adheres to the sealing resin, or the surface that adheres to the adhesive for the covering case, is unevenly finished, then due to the anchoring effect created by the sealing resin and the adhesive running into the unevenly finished section to bond the structural components, as well as the increase in adhesive area between the sealing resin, the adhesive, and each of the structural components, a high adhesive strength and stiffness can be obtained. In particular, roughening the outer peripheral surface of the terminal-supporting plate can easily prevent the sealing resin from peeling away from the terminal-supporting plate, even when a large external force is applied to the lead-out terminal, thereby enhancing the reliability of the semiconductor device.

By inclining the outer peripheral surface of the terminal-supporting plate upwardly and the surface of the covering case that faces said peripheral surface downwardly, when an external force is applied to the terminal-supporting plate, an anchoring effect by inclination, i.e. a wedge action, is produced, thereby protecting the terminal-supporting plate from slipping off. By roughening the inclined surface, the aforementioned effect can be enhanced and a preferred result can be expected.

By forming a configuration such that a first groove is prepared in the peripheral section of the upper surface of the metallic base plate, and a second, narrow, groove is prepared in the end face of the lower section of the covering case in such a way as to be deeper than said first groove, to be wider than the thickness of the outer wall of said first groove, and to have its inner wall thinner than the width of said first groove, and such that the metallic base plate and the covering case are made to adhere to each other using adhesive with the inner wall of said second groove fitted into said first groove and the outer wall of said first groove fitted into said second groove, the metallic base plate and the covering case can be made to adhere to each other over a wide interface, and with both the metallic base plate and the covering case interfitted with each other at the interface, thereby facilitating very strong bonding. Furthermore, since the second groove is deeper than the first groove, a surplus quantity of adhesive remains in the bottom of the second groove, thereby enabling enhanced adhesion, and preventing the adhesive from running out of the adhered section.

An exemplary embodiment of this invention is explained below with reference to the attached drawings, in which:
Figure 1 is a sectional view showing a first embodiment of the present device;
Figure 2 is a sectional view showing a preferred configuration of the present device;
Figure 3 is a sectional view of a conventional resin-sealed semiconductor device; and
Figure 4 is a sectional view of a second conventional resin-sealed semiconductor device.
In the drawings, components which correspond to components shown in Figures 3 and 4 are designated by the same reference numbers.

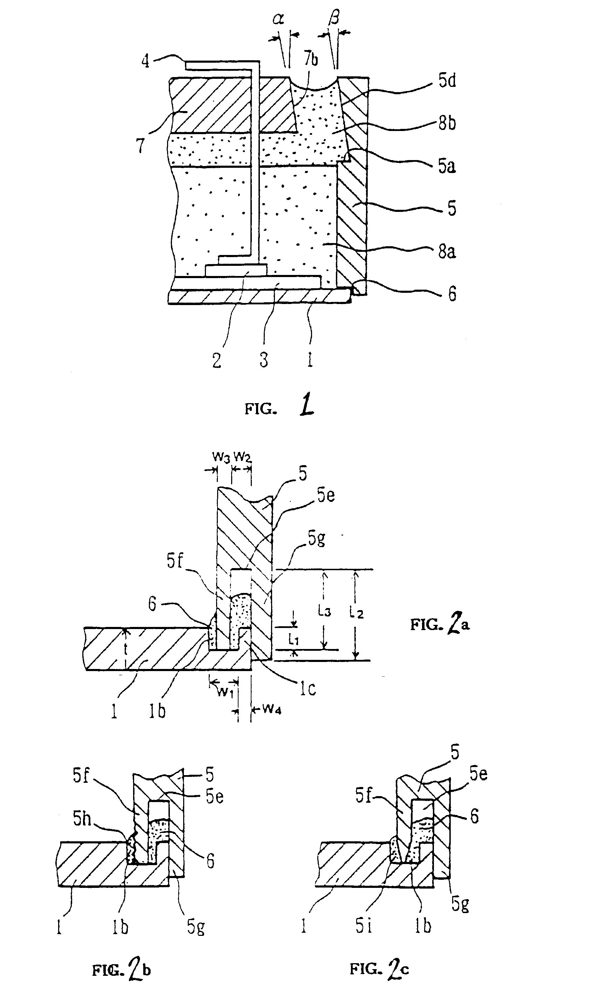

Figure 1 shows an embodiment of this invention, in which the outer peripheral surface of terminal-supporting plate 7 is made to incline so as to face upwardly and the inclined surface is inclined face 7b where the angle a of the contact surface between the outer peripheral surface of terminal-supporting plate 7 and sealing resin 8 is greater than 0°, and the surface 5b of covering case 5 facing inclined face 7b is made to incline so as to face downwardly, the angle β of the contact surface between the surface 5b of covering case 5 facing inclined face 7b and sealing resin 8 is greater than 0°. Inclining the contact surface between the outer peripheral surface of terminal-supporting plate 7 and sealing resin 8 and that part of the contact surface between the surface of covering case 5 facing the former inclined surface, and sealing resin 8 will prevent terminal-supporting plate 7 from slipping when an external force is applied to lead-out terminal 4. Although such an effect can be obtained also by inclining only the outer peripheral surface of terminal-supporting plate 7, it is found that by also inclining the part of the surface of covering case 5 facing the slanting surface, the effect of protecting terminal-supporting plate 7 from slipping is improved. The above inclination can be achieved by changing the moulding die or by cutting after moulding. Furthermore, unevenly finishing these slanting surfaces is the most preferred method to obtain a roughening effect.

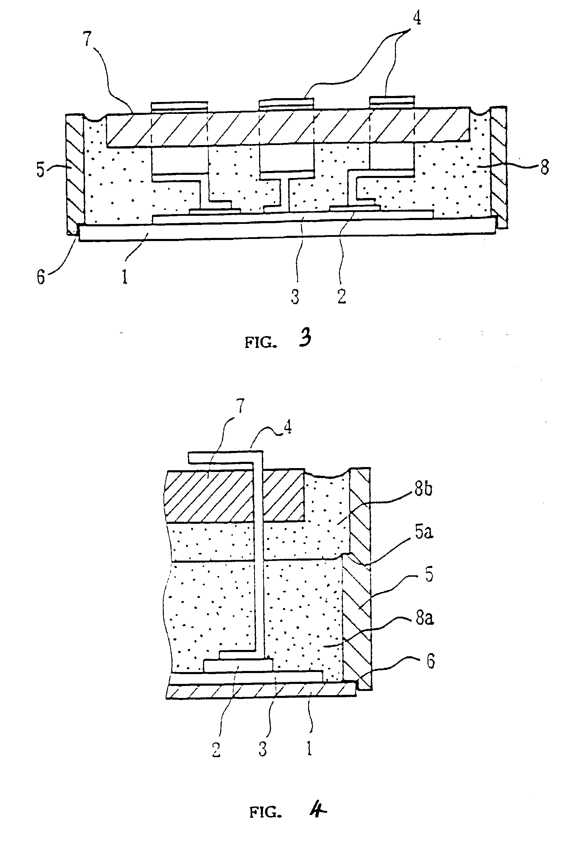

Figure 2 is an enlarged sectional view showing a preferred configuration of this invention, in which a groove is formed in the section adhered to metallic base plate 1 and in the section adhered to covering case 5, and these grooves are fitted into each other to securely adhere these sections, and in which each of Figures 2a, 2b, and 2c shows an example of a different configuration. In Figure 2a, a groove 1b of width W₁ and depth L₁ is prepared in the peripheral section of metallic base plate 1; a groove 5e of width W₂ and depth L₂ is prepared in the end face of covering case 5, and 1c indicates an outer wall bounding groove 1b. The reference numbers 5f and 5g indicate the inner wall and outer wall, respectively, of groove 5e. In terms of physical dimensions, the relationships between height L₃ and width W₃ of inner wall 5f of groove 5e, and depth L₁ and width W₁ of groove 1b are such that L₃ > L₁, and W₃ < W₁, respectively. Furthermore, the relationship between the height of outer wall 5g of groove 5e (i.e. depth L₂ of groove 5e) and L₃ is that: L₂ > L₃. Therefore, if the thickness of the metallic base plate 1 is t, the relationship between L₂, L₃, t, and L₁ can be defined as: L₂ < L₃ + t - L₁, and the relationship between width W₄ of outer wall 1c of groove 1b and width W₂ of groove 1b is W₄ < W₂. Accordingly, when adhering metallic base plate 1 to covering case 5, the tip of inner wall 5f can be fitted into groove 1 b, and outer wall 1c can be fitted into groove 5e so as to interfit grooves 1b and 5e. Then, the tip of inner wall 5f butts against the bottom of groove 1b to form the vertical supporting section of covering case 5, and the tip of outer wall 5g does not extend as far as the lower surface of metallic base plate 1. Furthermore, a cavity exists in the bottom section of groove 5e. When filling groove 1b with adhesive 6 and adhering metallic base plate 1 to covering case 5 with grooves 1b and 5e interfitted with each other as stated above, they are made to adhere to each other over a wide adhesive area, and furthermore, since both grooves are interfitted with each other, metallic base plate 1 and covering case 5 will adhere strongly. In addition, since any surplus adhesive will remain in the cavity in the bottom section of groove 5e, the adhesive will not run outside the adhered section, nor for example, reach the lower surface of metallic base plate 1 to obstruct adhesion of the semiconductor device to an apparatus, and degrade the heat radiation of the device.

Figure 2b shows a configuration where outer surface 5h of inner wall 5f of groove 5e of covering case 5 is roughened to further strengthen adhesion as compared to the configuration of Figure 2a, and Figure 2c shows a configuration where the top section of groove 5e of the covering case is formed into taper 5i so that the adhesion area can be widened to enhance the adhesive strength and also make mould lubrication easier when moulding covering case 5.

When the outer peripheral surface of the terminal-supporting plate is inclined upwardly and the surface of the covering case facing the upwardly inclined surface is inclined downwardly, resistance to slipping off of the terminal-supporting plate when an external force is applied to the lead-out terminal can be enhanced. In this case, when either one of the inclined outer surface of the terminal-supporting plate or the inclined surface of the covering case facing the inclined outer surface is unevenly finished, the roughness strengthens the adhesion.

Furthermore, when a first groove is prepared on the peripheral section of the upper surface of the metallic base plate, and a second groove, deeper than the first groove, wider than the thickness of the outer wall of the first groove, and whose inner wall is thinner than the first groove, is prepared on the lower end face of the covering case, and the metallic base plate and the covering case are made to adhere to each other using adhesive with the inner wall of the second groove fitted into the first groove, and with the outer wall of the first groove fitted into the second groove, the metallic base plate and the covering case are made to adhere to each other very strongly. Moreover, since adhesive may remain in the cavity at the bottom of the second groove, the adhesive can be prevented from running outside the adhesive section, to reach the lower surface of the metallic base plate, and prevent the resin-sealed semiconductor device from adhering to an apparatus, eventually degrading the heat radiation. In this case, roughening the outer surface of the inner wall of the second groove causes the effect of roughening to be added to have a preferred result.

## Claims

1. A resin-sealed semiconductor device comprising a metallic base plate (1), a covering case (5) attached to the periphery of the metallic base plate (1), a semiconductor element (2) fixed on the metallic base plate (1), at least one lead-out terminal (4) drawn out upwardly above the upper surface of the covering case (5) from the surface electrodes on the semiconductor element (2), a terminal-supporting plate (7) connected to the lead-out terminal (4) and forming the upper surface of the covering case (5), and a sealing resin (8) for filling the inside of the covering case, characterised in that the outer peripheral surface (7b) of said terminal-supporting plate (7) is inclined so as to face upwards and the surface (5d) of the covering case (5) facing said peripheral surface (7b) is inclined so as to face downwards.

2. A resin-sealed semiconductor device as claimed in Claim 1, characterised in that at least one of the inclined outer peripheral surface (7b) of the terminal-supporting plate (7) and the other inclined surface (5d) of the covering case facing the inclined outer peripheral surface is roughened.

3. A resin-sealed semiconductor device as claimed in Claim 1, or Claim 2, characterised in that a first groove (1b) of width (W₁) and depth (L₁) is prepared on the periphery of the upper surface of the metallic base plate (1), spaced from the periphery of the upper surface of the metallic base plate (1) by a distance (W₄), and wherein a second groove (5e) of a depth (L₂) exceeding that of said first groove (1b), of width (W₂) greater than the distance (W₄) between the first groove (1b) and the periphery of the upper surface of the metallic base plate (1), and spaced from the inner face (5h) of the covering case (5) by a distance (W₃) less than the width (W₁) of said first groove (1b) is prepared on the end face of the lower section of the covering case (5), and wherein the metallic base plate (1) and the covering case (5) are made to adhere to each other with the portion (5f) of the covering case (5) between the inner face (5h) and the second groove (5e) fitted into said first groove (1b), and with the region (1c) between the periphery of the upper surface of the metallic base plate (1) and the first groove (1b) fitted into said second groove (5e).

4. A resin-sealed semiconductor device as claimed in Claim 3, characterised in that the surface (5h) remote from the second groove (5e) of the portion (5f) is roughened.

## Patentansprüche

1. Mit Kunstharz vergossene Halbleitervorrichtung mit einer Metallgrundplatte (1), einem Abdeckgehäuse (5), das am Umfang der Metallgrundplatte (1) angebracht ist, einem Halbleiterelement (2), das an der Metallgrundplatte (1) befestigt ist, mindestens einer Durchführungsklemme (4), die nach oben über die obere Oberfläche des Abdeckgehäuses (5) von den Oberflächenelektroden des Halbleiterelements (2) aus herausgezogen ist, einer Anschlußhalteplatte (7), die mit der Durchführungsklemme (4) verbunden ist und die obere Oberfläche des Abdeckgehäuses (5) bildet, und einem Vergußharz (8) zum Füllen des Inneren des Abdeckgehäuses, dadurch gekennzeichnet, daß die äußere Umfangsoberfläche (7b) der Anschlußhalteplatte (7) so geneigt ist, daß sie nach oben zeigt und die Oberfläche (5d) des Abdeckgehäuses (5), die der Umfangsoberfläche (7b) gegenüberliegt, so geneigt ist, daß sie nach unten zeigt.

2. Mit Kunstharz vergossene Halbleitervorrichtung nach Anspruch 1, dadurch gekennzeichnet, daß mindestens eine der geneigten äußeren Umfangsoberfläche (7b) der Anschlußhalteplatte (7) und der anderen geneigten Oberfläche (5d) des Abdeckgehäuses, die der geneigten äußeren Umfangsoberfläche gegenüberliegt, gerauht ist.

3. Mit Kunstharz vergossene Halbleitervorrichtung nach Anspruch 1 oder 2, dadurch gekennzeichnet, daß eine erste Rille (1b) der Breite (Wl) und der Tiefe (L1) am Umfang der oberen Oberfläche der Metallgrundplatte (1) hergestellt ist, die vom Umfang der oberen Oberfläche der Metallgrundplatte (1) durch einen Abstand (W4) beabstandet ist, und worin eine zweite Rille (5e) einer Tiefe (L2), die jene der ersten Rille (1 b) übertrifft, einer Breite (W2), die größer als der Abstand (W4) zwischen der ersten Rille (1b) und dem Umfang der oberen Oberfläche der Metallgrundplatte (1) ist und von der Innenseite (5h) des Abdeckgehäuses (5) durch einen (W3) beabstandet ist, der geringer als die Breite (W1) der ersten Rille (1 b) ist, an der Endfläche des unteren Abschnitts des Abdeckgehäuses (5) hergestellt ist, und worin die Metallgrundplatte (1) und das Abdeckgehäuse (5) so hergestellt sind, daß sie aneinander kleben, wobei der Abschnitt (5f) des Abdeckgehäuses (5) zwischen der Innenseite (5h) und der zweiten Rille (5e) in die erste Rille (1b) eingepaßt ist, und wobei der Bereich (lc) zwischen dem Umfang der oberen Oberfläche der Metallgrundplatte (1) und der ersten Rille (1b) in die zweite Rille (5e) eingepaßt ist.

4. Mit Kunstharz vergossene Halbleitervorrichtung nach Anspruch 3, dadurch gekennzeichnet, daß die Oberfläche (5h), die von der zweite Rille (5e) des Abschnitts (5f) entfernt ist, gerauht ist.

## Revendications

1. Dispositif semi-conducteur scellé par une résine, comprenant une plaque métallique de base (1), un capot (5) fixé au pourtour de la plaque métallique de base (1), un élément semi-conducteur (2) fixé sur la plaque métallique de base (1), au moins une borne (4) de sortie s'étendant vers le haut au-dessus de la surface supérieure du capot (5) depuis les électrodes de surface de l'élément semi-conducteur (2), une plaque (7) de support de borne reliée à la borne (4) de sortie et formant la surface supérieure du capot (5), et une résine d'étanchéité (8) servant à remplir l'intérieur du capot, caractérisé en ce que la surface périphérique extérieure (7b) de ladite plaque (7) de support de borne est inclinée de façon à être orientée vers le haut et la surface (5d) du capot (5) en regard de ladite surface périphérique (7b) est inclinée de façon à être orientée vers le bas.

2. Dispositif semi-conducteur scellé par une résine selon la revendication 1, caractérisé en ce qu'au moins une des surfaces comprenant la surface périphérique extérieure inclinée (7b) de la plaque (7) de support de borne et l'autre surface inclinée (5d) du capot en regard de la surface périphérique extérieure inclinée est dépolie.

3. Dispositif semi-conducteur scellé par une résine selon la revendication 1 ou la revendication 2, caractérisé en ce qu'une première gorge (1b) de largeur (W₁) et de profondeur (L₁) est réalisée sur le pourtour de la surface supérieure de la plaque métallique de base (1), espacée du pourtour de la surface supérieure de la plaque métallique de base (1) d'une distance (W₄), et dans lequel une deuxième gorge (5e) d'une profondeur (L₂) supérieure à celle de ladite première gorge (1b), d'une largeur (W₂) supérieure à la distance (W₄) entre la première gorge (1g) et le pourtour de la surface supérieure de la plaque métallique de base (1), et espacée de la face interne (5h) du capot (5) d'une distance (W₃) inférieure à la largeur (W₁) de ladite première gorge (1b) est réalisée sur la face d'extrémité de la partie inférieure du capot (5), et dans lequel la plaque métallique de base (1) et le capot (5) sont amenés à adhérer l'un à l'autre, la partie (5f) du capot (5) entre la face interne (5h) et la deuxième gorge (5e) étant logée dans ladite première gorge (1b), et la partie (1c) entre le pourtour de la surface supérieure de la plaque métallique de base (1) et la première gorge (1b) étant logée dans ladite deuxième gorge (5e).

4. Dispositif semi-conducteur scellé par une résine selon la revendication 3, caractérisé en ce que la surface (5h) éloignée de la deuxième gorge (5e) de la partie (5f) est dépolie.
